(19) Europäisches Patentamt
European Patent Office
Office européen des brevets

(11) EP 2 654 389 B1

# (12) EUROPEAN PATENT SPECIFICATION

(45) Date of publication and mention of the grant of the patent:
**04.03.2015 Bulletin 2015/10**

(21) Application number: **13164069.0**

(22) Date of filing: **17.04.2013**

(51) Int Cl.:
***H05K 3/32*** (2006.01) ***H05K 3/36*** (2006.01)
***H01L 23/00*** (2006.01) ***B23K 35/36*** (2006.01)
***C08G 59/62*** (2006.01) ***C09J 9/02*** (2006.01)
***C09J 163/00*** (2006.01) *H05K 3/34* (2006.01)
*B23K 35/02* (2006.01) *B23K 35/30* (2006.01)

(54) **Joining sheet, electronic component, and producing method thereof**

Verbindungsschicht, elektronisches Bauteil und Herstellungsverfahren

Feuille de jonction, composant électronique et procédé de fabrication associé

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.04.2012 JP 2012096856**

(43) Date of publication of application:
**23.10.2013 Bulletin 2013/43**

(73) Proprietor: **NITTO DENKO CORPORATION**
**Ibaraki-shi,**
**Osaka 567-8680 (JP)**

(72) Inventors:
- **Ebe, Hirofumi**
  **Ibaraki-shi**
  **Osaka, 567-8680 (JP)**
- **Furukawa, Yoshihiro**
  **Ibaraki-shi**
  **Osaka, 567-8680 (JP)**

(74) Representative: **Hoffmann Eitle**
**Patent- und Rechtsanwälte PartmbB**
**Arabellastraße 30**
**81925 München (DE)**

(56) References cited:
**US-B2- 7 575 150** **US-B2- 7 838 984**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 654 389 B1

**Description**

BACKGROUND OF THE INVENTION

Field of the Invention

The present invention relates to a joining sheet, and a producing method thereof, to be specific, to a joining sheet, a method for producing a joining sheet, and a method for producing an electronic component.

Description of Related Art

Conventionally, it has been known that a solder paste which contains solder particles made of tin-bismuth based solder or the like and an active agent such as a carboxylic acid is used in the joining of terminals of two pieces of wired circuit boards. The tin-bismuth based solder particles are capable of being melted at low temperature. However, a solder joining portion which is formed by heating the tin-bismuth based solder particles to be melted has a low shock resistance and a low joining reliability. Therefore, in order to improve these properties, a solder paste which contains a thermosetting resin such as an epoxy resin in addition to the above-described solder paste has been proposed (ref: for example, Japanese Unexamined Patent Publication No. 2006-150413).

In Japanese Unexamined Patent Publication No. 2006-150413, the solder paste is applied to the surface of a terminal by a screen printing or the like and next, another terminal is brought into contact with the solder paste to be then heated. In this way, the solder particles are easily melted by the active agent, and the solder joining portion which is formed of the solder particles and a resin layer which is formed around the solder joining portion and reinforces the solder joining portion by allowing the thermosetting resin to be cured are formed, so that the two terminals are solder joined.

Document US 7 838 984 B2 discloses an adhesive tape for electrically connecting conductive components such as electrodes, the adhesive tape comprising solder powder, a thermosetting resin, a thermoplastic resin, and a carboxylic acid. Document US 7 575 150 B2 discloses solder pastes comprising solder powder and a soldering flux composition containing a blocked carboxylic acid.

SUMMARY OF THE INVENTION

In recent years, with the refinement of a terminal of an electronic component, there is a disadvantage that when printing is performed using the solder paste in Japanese Unexamined Patent Publication No. 2006-150413, the technology for refinement of printing is required and an industrial burden becomes heavy. Therefore, it is desired that a solder material is formed into a sheet shape.

However, when the active agent and the thermosetting resin are mixed to be formed into a sheet shape, there may be a case where the thermosetting resin reacts with the active agent by heating at the time of formation, so that the active agent is deactivated. As a result, there is a disadvantage that the melting of the solder particles becomes insufficient at the time of heating the sheet to be solder joined, so that the solder joining portion is not capable of being formed and therefore, the reliability of the electronic component to be obtained is reduced.

On the other hand, when the active agent is not added to the solder particles and the thermosetting resin, it is possible to form the solder particles and the thermosetting resin into a sheet shape. However, there is a disadvantage that the melting of the solder particles becomes insufficient, so that the solder joining portion is also not capable of being formed and therefore, the reliability of the electronic component to be obtained is reduced.

It is an object of the present invention to provide a joining sheet in which solder melting is excellent and which is capable of easily solder joining, a method for producing a joining sheet, and a method for producing an electronic component.

A joining sheet of the present invention contains solder particles, a thermosetting resin, a thermoplastic resin, and a blocked carboxylic acid.

In the joining sheet of the present invention, it is preferable that the blocked carboxylic acid is a reacting product of vinyl ether and a carboxylic acid.

In the joining sheet of the present invention, it is preferable that the vinyl ether is alkyl vinyl ether and the carboxylic acid is a bifunctional carboxylic acid.

In the joining sheet of the present invention, it is preferable that the dissociation temperature of the blocked carboxylic acid is 150°C or more.

In the joining sheet of the present invention, it is preferable that the volume ratio of the thermosetting resin to the thermoplastic resin is 25:75 to 75:25.

In the joining sheet of the present invention, it is preferable that the thermosetting resin is an epoxy resin.

In the joining sheet of the present invention, it is preferable that the thermoplastic resin is an acrylic resin.

In the joining sheet of the present invention, it is preferable that the solder particles are made of a tin-bismuth alloy.
In the joining sheet of the present invention, it is preferable that the joining sheet further contains a curing agent.
A method for producing a joining sheet of the present invention includes preparing a mixture by mixing solder particles, a thermosetting resin, a thermoplastic resin, and a blocked carboxylic acid to heat the mixture at a temperature that is below the dissociation temperature of the blocked carboxylic acid and below the melting point of the solder particles, and not less than the softening temperature of the thermoplastic resin to be formed into a sheet shape.
A method for producing an electronic component of the present invention includes the steps of preparing a laminate in which the above-described joining sheet is disposed between two pieces of wired circuit boards arranged so that corresponding terminals thereof are spaced in opposed relation to each other and heating the laminate at a temperature of either not less than the dissociation temperature of the blocked carboxylic acid or not less than the melting point of the solder particles, whichever is higher.
An electronic component of the present invention is obtained by the above-described method for producing an electronic component.
In the method for producing a joining sheet of the present invention, the solder particles, the thermosetting resin, the thermoplastic resin, and the blocked carboxylic acid are mixed to prepare a mixture. The obtained mixture is heated at a temperature that is below the dissociation temperature of the blocked carboxylic acid and below the melting point of the solder particles, and not less than the softening temperature of the thermoplastic resin to be formed into a sheet shape. That is, by using the blocked carboxylic acid and the thermoplastic resin in combination, the thermoplastic resin can be plasticized to be easily formed into a sheet shape by heating, while the reaction of the carboxylic acid with the thermosetting resin can be suppressed even by heating at the time of formation.
In the joining sheet of the present invention, at the time of performing solder joining by heating, the carboxylic acid is dissociated from the blocked carboxylic acid and the carboxylic acid functions as an active agent with respect to the solder particles so as to allow the solder particles to easily melt. Accordingly, the solder joining portion made of the solder material can be surely formed.
In the method for producing an electronic component of the present invention, the above-described joining sheet is disposed between the two pieces of wired circuit boards to prepare the laminate. Thereafter, the laminate is heated at a temperature of either not less than the dissociation temperature of the blocked carboxylic acid or not less than the melting point of the solder particles, whichever is higher. Therefore, the two pieces of wired circuit boards can be easily joined by the joining sheet without using a highly-advanced printing technology and the excellent solder melting is possible, so that the solder joining portion which electrically connects the terminals can be surely formed.

BRIEF DESCRIPTION OF THE DRAWINGS

FIG. 1 shows process drawings for illustrating one embodiment of a method for producing an electronic component of the present invention:

- FIG. 1 (a) illustrating a step of preparing a joining sheet and wired circuit boards,
- FIG. 1 (b) illustrating a step of laminating the joining sheet and the wired circuit boards,
- FIG. 1 (c) illustrating a step of compressively bonding the joining sheet to the wired circuit boards, and
- FIG. 1 (d) illustrating a step of solder joining the joining sheet to the wired circuit boards.

DETAILED DESCRIPTION OF THE INVENTION

A joining sheet of the present invention contains solder particles, a thermosetting resin, a thermoplastic resin, and a blocked carboxylic acid. To be specific, the joining sheet of the present invention is formed from a solder composition which contains the solder particles, the thermosetting resin, the thermoplastic resin, and the blocked carboxylic acid into a sheet shape.
An example of a solder material which forms the solder particles includes, for example, in view of environmental acceptability, a solder material which does not contain lead (a lead-free solder material). To be specific, an example thereof includes a tin alloy such as a tin-bismuth alloy (Sn-Bi) and a tin-silver-copper alloy (Sn-Ag-Cu). In view of low temperature joining, preferably, a tin-bismuth alloy is used.
The content ratio of the tin in the tin-bismuth alloy is, for example, 10 to 50 mass %, or preferably 25 to 45 mass % and the content ratio of the bismuth therein is, for example, 50 to 90 mass %, or preferably 55 to 75 mass %.
The melting point of the solder material (that is, the melting point of the solder particles) is, for example, 240°C or less, or preferably 200°C or less, and is, for example, 100°C or more, or preferably 130°C or more. The melting point is obtained by a differential scanning calorimetry (DSC).

The shape of each of the solder particles is not particularly limited and examples of the shape thereof include a sphere shape, a plate shape, and a needle shape. Preferably, a sphere shape is used.

The average value of the maximum length (in the case of a sphere shape, the average particle size) of each of the solder particles is, for example, 10 to 50 μm, or preferably 20 to 40 μm. When the average value of the maximum length of each of the solder particles is below the above-described range, there may be a case where the solder particles do not easily come into contact with each other at the time of heating and melting and an unmelted residue is left. On the other hand, when the average value of the maximum length of each of the solder particles is above the above-described range, the thinning of the joining sheet may be difficult.

The average value of the maximum length is measured using a laser diffraction scattering particle size analyzer.

Generally, the surface of each of the solder particles is covered with an oxide film made of an oxide of the solder material. The thickness of the oxide film is, for example, 1 to 20 nm.

The content ratio of the solder particles with respect to the solder composition is, for example, 40 to 90 volume %, or preferably 50 to 80 volume %. When the content ratio thereof is below the above-described range, there may be a case where the solder particles cannot come into contact with each other at the time of melting and therefore, cannot aggregate. On the other hand, when the content ratio thereof is above the above-described range, there may be a case where the filling of the joining sheet with the solder particles is difficult, so that the processing of the solder composition into the joining sheet in a sheet shape becomes difficult.

These solder particles can be used alone or in combination of two or more.

The solder composition contains a resin composition which is prepared from a thermosetting resin and a thermoplastic resin, and a curing agent contained if necessary, to be described later.

The content ratio of the resin composition with respect to the solder composition is, for example, 10 to 60 volume %, or preferably 20 to 50 volume %.

Examples of the thermosetting resin include an epoxy resin, a urea resin, a melamine resin, a diallyl phthalate resin, a silicone resin, a phenol resin, a thermosetting acrylic resin, thermosetting polyester, thermosetting polyimide, and thermosetting polyurethane. Preferably, an epoxy resin and thermosetting polyurethane are used, or particularly preferably, an epoxy resin is used.

Examples of the epoxy resin include an aromatic epoxy resin such as a bisphenol epoxy resin (for example, a bisphenol A epoxy resin, a bisphenol F epoxy resin, a bisphenol S epoxy resin, a hydrogenated bisphenol A epoxy resin, a dimer acid-modified bisphenol epoxy resin, and the like), a novolak epoxy resin (for example, a phenol novolak epoxy resin, a cresol novolak epoxy resin, a biphenyl epoxy resin, and the like), a naphthalene epoxy resin, a fluorene epoxy resin (for example, a bisaryl fluorene epoxy resin and the like), and a triphenylmethane epoxy resin (for example, a trishydroxyphenylmethane epoxy resin and the like); a nitrogen-containing-cyclic epoxy resin such as triepoxypropyl isocyanurate (triglycidyl isocyanurate) and a hydantoin epoxy resin; an aliphatic epoxy resin; an alicyclic epoxy resin (for example, a dicyclo ring-type epoxy resin and the like); glycidylether epoxy resin; and a glycidylamine epoxy resin.

As the epoxy resin, preferably, an aromatic epoxy resin is used, more preferably, a bisphenol epoxy resin is used, or particularly preferably, a bisphenol F epoxy resin is used.

A commercially available product can be used as the epoxy resin. To be specific, YSLV-80XY (a bisphenol F epoxy resin, manufactured by NIPPON STEEL CHEMICAL CO., LTD.) or the like is used.

These thermosetting resins can be used alone or in combination of two or more.

The curing temperature at which the thermosetting resin starts curing is, for example, 100 to 200°C, or preferably 150 to 180°C. The curing temperature can be measured with a thermomechanical analysis apparatus.

The content ratio of the thermosetting resin with respect to the resin composition is, for example, 10 to 50 volume %, or preferably 15 to 45 volume %.

The thermoplastic resin is blended in the solder composition so as to surely form the thermosetting resin into a sheet shape. To be specific, examples of the thermoplastic resin include polyolefin (for example, polyethylene, polypropylene, and an ethylene-propylene copolymer), an acrylic resin, polyester, polyvinyl acetate, an ethylene-vinyl acetate copolymer, polyvinyl chloride, polystyrene, polyacrylonitrile, polyamide (nylon (trade mark)), polycarbonate, polyacetal, polyethylene terephthalate, polyphenylene oxide, polyphenylene sulfide, polysulfone, polyether sulfone, poly ether ether ketone, polyallyl sulfone, thermoplastic polyimide, thermoplastic polyurethane, polyamino-bismaleimide, polyamide-imide, polyether-imide, a bismaleimide-triazine resin, polymethylpentene, a fluorine resin, a liquid crystal polymer, an olefin-vinyl alcohol copolymer, ionomer, polyarylate, an acrylonitrile-ethylene-styrene copolymer, an acrylonitrile-butadiene-styrene copolymer, an acrylonitrile-styrene copolymer, and a butadiene-styrene copolymer.

As the thermoplastic resin, preferably, an acrylic resin and polyester are used, or more preferably, an acrylic resin is used.

The acrylic resin is made of an acrylic polymer. The acrylic polymer is a polymer of a monomer which contains, as a main component, an alkyl (meth)acrylate containing an alkyl portion having 1 to 12 carbon atoms such as methyl (meth)acrylate, ethyl (meth)acrylate, propyl (meth)acrylate, butyl (meth)acrylate, hexyl (meth)acrylate, octyl (meth)acrylate, decyl (meth)acrylate, and dodecyl (meth)acrylate. These monomers can be used alone or in combination.

A commercially available product can be used as the acrylic polymer. To be specific, examples thereof include LA polymer (manufactured by KURARAY CO., LTD.), SG-700AS (manufactured by Nagase ChemteX Corporation), and UC-3510 (manufactured by TOAGOSEI CO., LTD.).

The softening temperature of the thermoplastic resin is, for example, 80 to 140°C, or preferably 100 to 130°C. The softening temperature can be measured with a thermomechanical analysis apparatus.

These thermoplastic resins can be used alone or in combination of two or more.

The content ratio of the thermoplastic resin with respect to the resin composition is, for example, 20 to 80 volume %, or preferably 30 to 70 volume %. The volume ratio of the thermosetting resin to the thermoplastic resin is, for example, 25:75 to 75:25, or preferably 40:60 to 60:40. When the content ratio thereof is above the above-described range, it may be difficult to form the thermosetting resin into a sheet shape. On the other hand, when the content ratio thereof is below the above-described range, the joining reliability may be reduced.

The blocked carboxylic acid is a reacting product of a carboxylic acid and a blocking agent; a compound in which a carboxyl group in the carboxylic acid is protected by the blocking agent; and a compound which is dissociated into the carboxylic acid and the blocking agent again by heating.

Examples of the carboxylic acid include a monofunctional carboxylic acid and a polyfunctional carboxylic acid. Examples of the monofunctional carboxylic acid include a straight chain or branched chain saturated aliphatic monofunctional carboxylic acid such as an acetic acid, a propionic acid, a butyric acid, and a laurylic acid; a straight chain or branched chain unsaturated aliphatic monofunctional carboxylic acid such as an acrylic acid and a methacrylic acid; and an aromatic monofunctional carboxylic acid such as a benzoic acid and a 2-phenoxybenzoic acid.

An example of the polyfunctional carboxylic acid includes a bifunctional carboxylic acid such as a straight chain or branched chain saturated aliphatic bifunctional carboxylic acid including a succinic acid, an adipic acid, and a sebacic acid; a straight chain or branched chain unsaturated aliphatic bifunctional carboxylic acid including a maleic acid, a fumaric acid, and an itaconic acid; and an aromatic bifunctional carboxylic acid including a phthalic acid. As the polyfunctional carboxylic acid, a carboxylic acid having three or more functional groups such as a trimellitic acid and a pyromellitic acid is also used.

Also, examples of the carboxylic acid include a carboxylic acid obtained by allowing polyol to react with an acid anhydride or a carboxylic acid having two or more functional groups, a carboxylic acid obtained by allowing polyisocyanate to react with a hydroxycarboxylic acid or an amino acid, and a carboxylic acid obtained by homopolymerizing or copolymerizing an unsaturated carboxylic acid.

As the carboxylic acid, preferably, a polyfunctional carboxylic acid is used, more preferably, a bifunctional carboxylic acid is used, or particularly preferably, a saturated aliphatic bifunctional carboxylic acid is used.

An example of the blocking agent includes ether such as vinyl ether and vinyl thioether.

Examples of the vinyl ether include alkyl vinyl ether such as ethyl vinyl ether, n-propyl vinyl ether, isopropyl vinyl ether, n-butyl vinyl ether, isobutyl vinyl ether, t-butyl vinyl ether, and 2-ethylhexyl vinyl ether and cyclic vinyl ether such as dihydrofuran and pyran.

An example of the vinyl thioether includes ethyl(vinylthiomethyl) ether.

As the blocking agent, preferably, vinyl ether is used, or more preferably, alkyl vinyl ether is used.

As the blocked carboxylic acid, a reacting product of any combination of the above-described blocking agents and the above-described carboxylic acids may be used. Preferably, a reacting product (hemiacetal ester) of vinyl ether and a carboxylic acid is used, or more preferably, a reacting product of alkyl vinyl ether and a bifunctional carboxylic acid is used.

A commercially available product can be used as the blocked carboxylic acid. To be specific, Santacid H, Santacid I (both are manufactured by NOF CORPORATION), and the like are used. Also, the blocked carboxylic acid may be produced by allowing a commercially available product of the carboxylic acid to react with a commercially available product of the blocking agent by a known method.

The dissociation temperature of the blocked carboxylic acid, that is, the temperature at which the blocked carboxylic acid is dissociated (decomposed) into the carboxylic acid and the blocking agent by heating, is, for example, 125°C or more, or preferably 150°C or more, and is also, for example, 200°C or less. The dissociation temperature of the blocked carboxylic acid is higher than the softening temperature of the thermoplastic resin and the temperature difference therebetween is, for example, 10 to 50°C, or preferably 25 to 35°C.

In the blocked carboxylic acid, the carboxyl group in the carboxylic acid which serves as an active agent is protected by the blocking agent such as the vinyl ether, so that at normal temperature before solder joining; in the thermal history during the steps; or in heating and forming into a sheet, the activation potency based on the carboxyl group in the carboxylic acid becomes latent and the blocked carboxylic acid is inactive with respect to the thermosetting resin such as an epoxy resin having an epoxy group. On the other hand, in heating at the time of solder joining, the blocking agent is dissociated and the carboxylic acid is produced to be activated. For example, in the case of the reacting product of the bifunctional carboxylic acid and the alkyl vinyl ether, the reaction scheme is as follows.

Reaction Scheme

$$HOOC\text{-}R^1\text{-}COOH + 2CH_2 = CH\text{-}OR^2 \underset{\text{Dissociation (Thermal Decomposition)}}{\overset{\text{Addition Reaction}}{\rightleftharpoons}}$$

$$(R^2OCH\ (CH_3))\ OOC\text{-}R^1\text{-}COO\ (CH(CH_3)OR^2)$$

($R^1$ represents a divalent saturated or unsaturated aliphatic group or a divalent aromatic group and $R^2$ represents an alkyl group.)

Therefore, the oxide films on the surfaces of the solder particles are removed and the solder particles can be melted at a temperature that is the melting point of the solder material. In this way, the deactivation of the active agent due to the reaction of the blocked carboxylic acid with the epoxy resin at the time other than the time of the solder melting is suppressed and the solder melting can be excellently performed.

The content ratio of the blocked carboxylic acid with respect to 100 parts by mass of the solder particles is, for example, 0.05 to 5 parts by mass, or preferably 0.1 to 1 parts by mass.

Preferably, the solder composition contains a curing agent.

The curing agent is appropriately determined in accordance with the type of the thermosetting resin or the like. Examples thereof include a phenol resin, amines, and thiols. Preferably, a phenol resin is used.

Examples of the phenol resin include a novolak phenol resin obtained by condensing phenol and formaldehyde under an acidic catalyst and a phenol-aralkyl resin obtained by synthesizing phenol and dimethoxyparaxylene or bis(methoxymethyl)biphenyl.

Preferably, a phenol-aralkyl resin is used. A commercially available product can be used as the phenol-aralkyl resin. To be specific, MEH-7851SS, MEHC-7800H (the description above, manufactured by MEIWA PLASTIC INDUSTRIES, LTD.), and the like are used.

The content ratio of the curing agent with respect to the resin composition is, for example, 10 to 50 volume %, or preferably 15 to 45 volume %.

The solder composition can further contain a curing accelerator.

Examples of the curing accelerator include an imidazole compound, an imidazoline compound, an organic phosphine compound, an acid anhydride compound, an amide compound, a hydrazide compound, and a urea compound.

The content ratio of the curing accelerator with respect to 100 parts by mass of the thermosetting resin is, for example, 0.5 to 20 parts by mass, or preferably 1 to 10 parts by mass.

In addition to the above-described component, for example, in view of improving adhesive strength of the solder particles to the thermoplastic resin, the solder composition can contain an additive such as a silane coupling agent at an appropriate proportion as required.

In order to obtain the joining sheet, for example, first, the solder composition which contains the above-described solder particles, thermosetting resin, thermoplastic resin, and blocked carboxylic acid is prepared. For example, the above-described solder particles, thermosetting resin, thermoplastic resin, and blocked carboxylic acid (and the curing agent, the curing accelerator, and the additive contained if necessary) are kneaded with, for example, a kneader or the like, so that the solder composition is prepared as a kneaded product (a mixture). To be more specific, first, the thermosetting resin, the thermoplastic resin, and the curing agent are kneaded to prepare a resin composition containing those components and next, the solder particles and the blocked carboxylic acid are sequentially blended into the resin composition.

The kneading temperature is not particularly limited as long as it is a temperature that is below the melting point of the solder particles and not less than the softening temperature of the thermoplastic resin. To be specific, the kneading temperature is, for example, 80 to 135°C, or preferably 100 to 130°C.

Next, the kneaded product is molded into a sheet shape by, for example, a method such as a calender rolling, a press molding, or an extrusion molding. The molding temperature is a temperature that is below the dissociation temperature of the blocked carboxylic acid and below the melting point of the solder particles, and not less than the softening temperature of the thermoplastic resin. To be specific, the molding temperature is, for example, 80 to 135°C, or preferably 100 to 130°C. In this way, the joining sheet is formed. Preferably, the joining sheet is in a B-stage state (a semi-cured state).

The reaction rate (described in detail in Examples to be described later) of the epoxy group in the joining sheet is, for example, 60 % or less, or preferably 50 % or less. When the reaction rate of the epoxy group is above the above-described range, there may be a case where the reaction of the carboxyl group based on the blocked carboxylic acid with the epoxy group is excessively progressed, so that the ability to remove the oxide films on the surfaces of the solder particles is reduced and the solder melting becomes insufficient.

The thickness of the joining sheet is, for example, 10 to 200 μm, or preferably 20 to 100 μm. When the thickness is below the above-described range, the thickness of the joining sheet is thinner than the average particle size of each of the solder particles, so that it may be difficult to process the joining sheet into a sheet shape. On the other hand, when the thickness is above the above-described range, there may be a disadvantage in terms of cost.

The solder particles, the thermosetting resin, the thermoplastic resin, and the blocked carboxylic acid (and the curing agent, the curing accelerator, and the additive contained if necessary) are blended into, for example, a solvent to prepare a varnish. The prepared varnish is applied to a substrate to be thereafter dried, so that the joining sheet can be also obtained.

Furthermore, the joining sheet can be also formed by any of a batch process and a continuous process.

FIG. 1 shows process drawings for illustrating one embodiment of a method for producing an electronic component of the present invention: FIG. 1 (a) illustrating a step of preparing a joining sheet and wired circuit boards, FIG. 1 (b) illustrating a step of laminating the joining sheet and the wired circuit boards, FIG. 1 (c) illustrating a step of compressively bonding the joining sheet to the wired circuit boards, and FIG. 1 (d) illustrating a step of solder joining the joining sheet to the wired circuit boards.

Next, a method for producing an electronic component using the joining sheet as an electrically conductive joining sheet is described with reference to FIG. 1.

In this method, first, as shown in FIG. 1 (a), a joining sheet 5 and two pieces of wired circuit boards 2 are prepared.

The joining sheet 5 can be obtained by the above-described method and in the joining sheet 5, solder particles 4 are dispersed in the thermosetting resin and the thermoplastic resin.

Each of the wired circuit boards 2 is provided with a board 3 and a wired circuit which is provided on the surface of the board 3 and has terminals 1. The board 3 is formed into a flat plate shape and is formed of an insulating board or the like. A plurality of the terminals 1 are made of metal and are disposed at spaced intervals to each other. The maximum length of each of the terminals 1 is, for example, 50 to 1000 μm. The gap between the terminals 1 is, for example, 50 to 1000 μm.

Next, as shown in FIG. 1 (b), the wired circuit boards 2 and the joining sheet 5 are laminated. That is, first, as shown in FIG. 1 (a), the two pieces of wired circuit boards 2 are disposed at spaced intervals to each other in the thickness direction (the up-down direction in FIG. 1). To be specific, the two pieces of wired circuit boards 2 are disposed in opposed relation to each other so that the terminals 1 of the upper-side wired circuit board 2 are disposed in opposed relation to those of the lower-side wired circuit board 2 in the thickness direction. Subsequently, the joining sheet 5 is interposed between the two pieces of wired circuit boards 2.

Next, as shown in FIG. 1 (b), the two pieces of wired circuit boards 2 are allowed to be closer to each other and the wired circuit boards 2 are brought into contact with the joining sheet 5. To be specific, surfaces 10 of the terminals 1 of the upper-side wired circuit board 2 are brought into contact with the surface (one surface in the thickness direction) of the joining sheet 5 and the surfaces 10 of the terminals 1 of the lower-side wired circuit board 2 are brought into contact with the bottom surface (the other surface in the thickness direction) of the joining sheet 5. In this way, a laminate 6 is obtained.

Next, as shown in FIG. 1 (c), the laminate 6 is heated at a temperature that is below the dissociation temperature of the blocked carboxylic acid and below the melting point of the solder particles 4, and not less than the softening temperature of the thermoplastic resin and the two pieces of wired circuit boards 2 are pressed toward (subjected to thermal compression bonding to) the joining sheet 5.

The temperature in the thermal compression bonding may be appropriately determined in accordance with the type of the thermosetting resin, the thermoplastic resin, the blocked carboxylic acid, or the like. The temperature is, for example, 100 to 140°C, or preferably 110 to 135°C and the pressure is, for example, 0.05 to 10 MPa, or preferably 0.1 to 5 MPa.

In this way, the thermoplastic resin in the joining sheet 5 is melted or moved, so that the terminals 1 are embedded in the joining sheet 5. That is, the surfaces 10 and side surfaces 11 of the terminals 1 are covered with the joining sheet 5.

Along with this, a surface 12, which is an exposed portion from the terminals 1 on the board 3, is covered with the joining sheet 5.

Next, in this method, as shown in FIG. 1 (d), the laminate 6 is heated.

The heating temperature is a temperature of either not less than the dissociation temperature of the blocked carboxylic acid or not less than the melting point of the solder particles 4, whichever is higher. The heating temperature may be appropriately determined in accordance with the type of the solder material, the blocked carboxylic acid, or the

like and to be specific, is, for example, 140 to 200°C, or preferably 150 to 180°C. When the heating temperature is below the above-described range, the solder particles 4 are not melted and the solder joining becomes insufficient.

In this way, the two pieces of wired circuit boards 2 are joined by the joining sheet 5 and each of the terminals 1 corresponding to each of the wired circuit boards 2 is electrically connected to each other.

That is, the terminals 1 are solder joined in the thickness direction. To be specific, the solder particles 4 in the joining sheet 5 are easily melted by a carboxylic acid produced by the dissociation from the blocked carboxylic acid by heating and aggregate (self-aggregate) between the terminals 1 which are opposed to each other in the thickness direction to form solder joining portions 7 (portions made of the solder material). On the other hand, the thermosetting resin and the thermoplastic resin are expelled by the self-aggregating solder particles 4 and move around the solder joining portions 7. Thereafter, the expelled thermosetting resin is thermally cured, so that a cured layer 8 which reinforces the solder joining portions 7 is formed. Preferably, the cured layer 8 contains a thermosetting resin in a C-stage state (a completely cured state) and a thermoplastic resin.

Each of the solder joining portions 7 is formed into a generally column shape extending along the thickness direction and is formed so that the its cross-sectional area in a direction perpendicular to the thickness direction is gradually reduced from the center in the thickness direction of the joining sheet 5 toward the top side and the bottom side. One surfaces in the thickness direction (the top surfaces) of the solder joining portions 7 are in contact with the surfaces 10 of the upper-side terminals 1. The other surfaces in the thickness direction (the bottom surfaces) of the solder joining portions 7 are in contact with the surfaces 10 of the lower-side terminals 1.

The cured layer 8 is in contact with the side surfaces 11 of the terminals 1 and the surface 12, which is the exposed portion from the terminals 1 on the board 3, and is present around the solder joining portions 7.

In this way, an electronic component 9 is obtained.

The solder particles 4, the thermosetting resin, the thermoplastic resin, and the blocked carboxylic acid are mixed to be heated at a temperature that is not less than the softening temperature of the thermoplastic resin, so that the joining sheet 5 is formed. That is, by using the blocked carboxylic acid and the thermoplastic resin in combination, the reaction of the carboxyl group in the carboxylic acid which serves as an active agent with the reaction group (for example, the epoxy group) in the thermosetting resin (for example, the epoxy resin) is suppressed, and the thermoplastic resin is plasticized at a temperature that is below the dissociation temperature of the blocked carboxylic acid and below the melting point of the solder particles, so that the solder composition is easily formed into a sheet shape. Therefore, in the joining sheet to be obtained, a relatively large number of the carboxyl groups which are latent in the blocked carboxylic acid are present and the solder particles are stably present. Therefore, in the solder joining of the electronic component 9, the solder melting of the solder particles 4 are excellent and the solder joining portions 7 made of the solder material can be surely formed. The joining sheet 5 is in a sheet shape, so that fine printing is not required and therefore, the solder joining can be easily performed.

In the embodiment of FIG. 1, in the lamination of the wired circuit boards 2 and the joining sheet 5, the joining sheet 5 is interposed between the two pieces of wired circuit boards 2. Alternatively, for example, though not shown, the joining sheet 5 is laminated on one wired circuit board 2 so that the joining sheet 5 is brought into contact with the terminals 1 of the wired circuit board 2 and thereafter, the other wired circuit board 2 can be laminated on the joining sheet 5 so that the terminals 1 of the other wired circuit board 2 are brought into contact with the joining sheet 5. That is, on one wired circuit board 2, the joining sheet 5 and the other wired circuit board 2 can be also sequentially laminated.

In the above-described embodiment, the joining sheet 5 is described as a one-layered structure in which the solder particles, the thermosetting resin, the thermoplastic resin, and the blocked carboxylic acid are contained. However, it is not necessarily required that the solder particles, the thermosetting resin, the thermoplastic resin, and the blocked carboxylic acid are present in the same layer and the joining sheet 5 can be also formed as a multiple-layered structure containing those components. In such a case, for example, the thermosetting resin and the thermoplastic resin may be contained in any layer.

Also, a release substrate can be laminated on one surface and/or the other surface in the thickness direction of the joining sheet 5.

## Examples

While the present invention will be described hereinafter in further detail with reference to Examples and Comparative Examples, the present invention is not limited to these Examples and Comparative Examples.

### Example 1

30 parts by volume of an epoxy resin (manufactured by NIPPON STEEL CHEMICAL CO., LTD., a thermosetting resin, YSLV-80XY, a curing temperature of 150°C), 40 parts by volume of an acrylic resin (manufactured by KURARAY CO., LTD., a thermoplastic resin, LA polymer, a softening temperature of 110°C), and 30 parts by volume of a phenol

resin (manufactured by MEIWA PLASTIC INDUSTRIES, LTD., a curing agent, MEH-7851SS) were mixed, so that a resin composition was obtained. The obtained resin composition and solder particles (Sn/Bi = 42 mass %/58 mass %, the melting point of 139°C, a sphere shape, an average particle size of 35 μm) were mixed at a volume ratio of the resin composition: the solder particles = 25:75. Furthermore, a blocked carboxylic acid (manufactured by NOF CORPORATION, Santacid H, a monoalkyl vinyl ether-blocked bifunctional low molecular weight carboxylic acid, a dissociation temperature of 160°C) was added to the obtained product at a ratio of 1 part by mass of the blocked carboxylic acid with respect to 100 parts by mass of the solder particles to be kneaded with a kneader, so that a mixture was obtained. The obtained mixture was molded into a sheet shape having a thickness of 50 μm at 125°C with a press molding machine, so that a joining sheet was fabricated.

Example 2

A joining sheet was fabricated in the same manner as in Example 1, except that the blocked carboxylic acid (manufactured by NOF CORPORATION, Santacid H, a monoalkyl vinyl ether-blocked bifunctional low molecular weight carboxylic acid, a dissociation temperature of 160°C) was changed to a blocked carboxylic acid (manufactured by NOF CORPORATION, Santacid I, a monoalkyl vinyl ether-blocked bifunctional carboxylic acid, a dissociation temperature of 170°C).

Comparative Example 1

A joining sheet was fabricated in the same manner as in Example 1, except that the blocked carboxylic acid (manufactured by NOF CORPORATION, Santacid H) was not added.

Comparative Example 2

A joining sheet was fabricated in the same manner as in Example 1, except that the blocked carboxylic acid (manufactured by NOF CORPORATION, Santacid H) was changed to an adipic acid.

Comparative Example 3

A joining sheet was fabricated in the same manner as in Example 1, except that the blocked carboxylic acid (manufactured by NOF CORPORATION, Santacid H) was changed to a sebacic acid.

Comparative Example 4

A joining sheet was fabricated in the same manner as in Example 1, except that the blocked carboxylic acid was changed to a 2-phenoxybenzoic acid.

Comparative Example 5

The fabrication of a joining sheet was attempted with a press molding machine by obtaining a mixture in the same manner as in Example 1, except that a resin composition was obtained by mixing 50 parts by volume of an epoxy resin and 50 parts by volume of a phenol resin without mixing an acrylic resin.
However, the mixture was not capable of being molded into a sheet shape.

Comparative Example 6

A mixture was obtained in the same manner as in Example 1, except that a resin composition was obtained by mixing 50 parts by volume of an epoxy resin and 50 parts by volume of a phenol resin without mixing an acrylic resin.
Next, the obtained mixture was dissolved into methyl ethyl ketone. Then, the dissolved product was applied to a polyethylene terephthalate substrate. Next, the applied product was heated at 120°C and was dried to be brought into a semi-cured state (a B-stage state). In this way, the fabrication of a joining sheet was attempted.
However, the dissolved product was not capable of being formed into a sheet shape.

(Performance Test)

Reaction Rate of Epoxy

In the joining sheets in Examples 1 to 2, and Comparative Examples 1 to 4 and 6, the residual ratio of the epoxy group was measured by an infrared spectroscopy measurement. The reaction rate was calculated based on a benzene ring in accordance with the following formula.

$$\text{The reaction rate} = [1 - (a/b) / (A/B)] \times 100\ \%$$

a: the absorption intensity of epoxy group in monomer mixture

(the peak position of 900 $cm^{-1}$ in infrared spectroscopy measurement)

b: the absorption intensity of benzene ring in monomer mixture

(the peak position of 1600 $cm^{-1}$ in infrared spectroscopy measurement)

A: the absorption intensity of epoxy group in joining sheet

(the peak position of 900 $cm^{-1}$ in infrared spectroscopy measurement)

B: the absorption intensity of benzene ring in joining sheet

(the peak position of 1600 $cm^{-1}$ in infrared spectroscopy measurement)

**[0119]** * The monomer mixture is a mixture obtained by dissolving 40 parts by volume of an epoxy resin and 40 parts by volume of a phenol resin into 20 parts by volume of methyl ethyl ketone.

Solder Melting A

Using, as adherends, copper foils which were not subjected to an anti-corrosion treatment, the joining sheets in Examples 1 to 2, and Comparative Examples 1 to 4 and 6 were sandwiched between the two copper foils from both sides thereof. The sandwiched product was subjected to a thermal compression bonding at 125°C and 1 MPa and then, was heated at 170°C for 30 minutes. In this way, the two copper foils were solder joined, so that a solder joined product was fabricated. Thereafter, the cross section of the obtained solder joined product was observed and the presence or absence of the solder melting was confirmed. The confirmation of the presence of the solder melting was evaluated as "Good". The confirmation of the presence of a partial solder melting was evaluated as "Poor". The confirmation of the absence of the solder melting was evaluated as "Bad".

The results of the above-described tests are shown in the following Table 1.

Table 1

| | | Ex. 1 | Ex. 2 | Comp. Ex. 1 | Comp. Ex. 2 | Comp. Ex. 3 | Comp. Ex. 4 | Comp. Ex. 5 | Comp. Ex. 6 |
|---|---|---|---|---|---|---|---|---|---|
| Solder Particles | 42Sn-58Bi (Parts by Volume) | 75 | 75 | 75 | 75 | 75 | 75 | 75 | 75 |
| Resin Composition | Total (Parts by Volume) | 25 | 25 | 25 | 25 | 25 | 25 | 25 | 25 |
| | Epoxy Resin (volume % in Resin Composition) | 30 | 30 | 30 | 30 | 30 | 30 | 50 | 50 |
| | Acrylic Resin (volume % in Resin Composition) | 40 | 40 | 40 | 40 | 40 | 40 | - | - |
| | Phenol Resin (volume % in Resin Composition) | 30 | 30 | 30 | 30 | 30 | 30 | 50 | 50 |
| Blocked Carboxylic Acid (Parts by Mass to 100 Parts by Mass of Solder Particles) | Santacid H | 1 | - | - | - | - | - | 1 | 1 |
| | Santacid I | - | 1 | - | - | - | - | - | - |
| Carboxylic Acid (Parts by Mass to 100 Parts by Mass of Solder Particles) | Adipic Acid | - | - | - | 1 | - | - | - | - |
| | Sebacic Acid | - | - | - | - | 1 | - | - | - |
| | 2-Phenoxybenzoic Acid | - | - | - | - | - | 1 | - | - |
| Evaluation | Reaction Rate of Epoxy | 45 | 45 | 43 | 88 | 83 | 71 | * | * |
| | Solder Melting | Good | Good | Bad | Bad | Bad | Poor | * | * |
| *Not capable of being formed into sheet shape | | | | | | | | | |

Example 3 (Performance Test of Solder Melting B of Joining Sheet in Example 1)

Two pieces of wired circuit boards each of which was provided with a board and a wired circuit that was formed on the surface of the board, was made of copper, and had terminals (an interval of 100 μm between the terminals) were prepared (ref: FIG. 1 (a)). The two pieces of wired circuit boards were arranged so that corresponding terminals thereof were spaced in opposed relation to each other. Thereafter, the joining sheet of Example 1 was interposed between the two pieces of wired circuit boards so as to be brought into contact therewith, so that a laminate was obtained (ref: FIG. 1 (b)). Next, the obtained laminate was subjected to a thermal compression bonding at 125°C and 1 MPa (ref: FIG. 1 (c)) to be then heated at 170°C for 30 minutes, so that an electronic component was fabricated (ref: FIG. 1 (d)).

The solder melting of the electronic component was examined and the solder melting was confirmed.

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

## Claims

**1.** A joining sheet (5) comprising:

solder particles (4), a thermosetting resin, a thermoplastic resin, and a blocked carboxylic acid.

**2.** The joining sheet according to claim 1, wherein
the blocked carboxylic acid is a reacting product of vinyl ether and a carboxylic acid.

**3.** The joining sheet according to claim 2, wherein
the vinyl ether is alkyl vinyl ether and the carboxylic acid is a bifunctional carboxylic acid.

**4.** The joining sheet according to claim 1, 2 or 3, wherein
the dissociation temperature of the blocked carboxylic acid is 150°C or more.

**5.** The joining sheet according to claim 1, 2, 3 or 4, wherein
the volume ratio of the thermosetting resin to the thermoplastic resin is 25:75 to 75:25.

**6.** The joining sheet according to claim 1, 2, 3, 4 or 5, wherein
the thermosetting resin is an epoxy resin.

**7.** The joining sheet according to claim 1, 2, 3, 4, 5 or 6, wherein
the thermoplastic resin is an acrylic resin.

**8.** The joining sheet according to claim 1, 2, 3, 4, 5, 6 or 7, wherein
the solder particles are made of a tin-bismuth alloy.

**9.** The joining sheet according to claim 1, 2, 3, 4, 5, 6, 7 or 8, wherein
the joining sheet further contains a curing agent.

**10.** A method for producing a joining sheet (5) comprising:

preparing a mixture by mixing solder particles (4), a thermosetting resin, a thermoplastic resin, and a blocked carboxylic acid to heat the mixture at a temperature that is below the dissociation temperature of the blocked carboxylic acid and below the melting point of the solder particles, and not less than the softening temperature of the thermoplastic resin to be formed into a sheet shape.

**11.** A method for producing an electronic component (9) comprising the steps of:

preparing a laminate in which a joining sheet (5) is disposed between two pieces of wired circuit boards (2) arranged so that corresponding terminals (1) thereof are spaced in opposed relation to each other, wherein the joining sheet (5) is a joining sheet according to claim 1; and
heating the laminate at a temperature of either not less than the dissociation temperature of the blocked carboxylic

acid or not less than the melting point of the solder particles (4), whichever is higher.

## Patentansprüche

1. Verbindungsschicht (5), umfassend:

   Lötpartikel (4), ein wärmehärtendes Harz, ein thermoplastisches Harz und eine blockierte Carbonsäure.

2. Verbindungsschicht gemäß Anspruch 1, worin die blockierte Carbonsäure ein Reaktionsprodukt aus Vinylether und einer Carbonsäure ist.

3. Verbindungsschicht gemäß Anspruch 2, worin der Vinylether ein Alkylvinylether ist und die Carbonsäure eine bifunktionelle Carbonsäure ist.

4. Verbindungsschicht gemäß Anspruch 1, 2 oder 3, worin die Dissoziationstemperatur der blockierten Carbonsäure 150°C oder mehr ist.

5. Verbindungsschicht gemäß Anspruch 1, 2, 3 oder 4, worin das Volumenverhältnis des wärmehärtenden Harzes zum thermoplastischen Harz 25:75 bis 75:25 ist.

6. Verbindungsschicht gemäß Anspruch 1, 2, 3, 4 oder 5, worin das wärmehärtende Harz ein Epoxyharz ist.

7. Verbindungsschicht gemäß Anspruch 1, 2, 3, 4, 5 oder 6, worin das thermoplastische Harz ein acrylisches Harz ist.

8. Verbindungsschicht gemäß Anspruch 1, 2, 3, 4, 5, 6 oder 7, worin die Lötpartikel aus einer Zinn-Wismut-Legierung hergestellt sind.

9. Verbindungsschicht gemäß Anspruch 1, 2, 3, 4, 5, 6, 7 oder 8, worin die Verbindungsschicht weiterhin ein Härtungsmittel enthält.

10. Verfahren zur Herstellung einer Verbindungsschicht (5), umfassend:

    Herstellung einer Mischung durch Mischen von Lötpartikeln (4), einem wärmehärtenden Harz, einem thermoplastischen Harz und einer blockierten Carbonsäure, um die Mischung auf eine Temperatur zu erwärmen, die unterhalb der Dissoziationstemperatur der blockierten Carbonsäure und unterhalb des Schmelzpunkts der Lötpartikel liegt, und die nicht niedriger ist als die Erweichungstemperatur des thermoplastischen Harzes, um zu einer Schichtform geformt zu werden.

11. Verfahren zur Herstellung einer elektronischen Komponente (9), das den folgenden Schritt umfasst:

    Herstellung eines Laminats, in dem eine Verbindungsschicht (5) zwischen zwei Leiterplatten (2) eingebracht ist, die so angeordnet sind, dass deren einander entsprechende Anschlüsse (1) einander in einem Abstand gegenüberliegen, worin
    die Verbindungsschicht (5) eine Verbindungsschicht gemäß Anspruch 1 ist; und
    Erwärmen des Laminats auf eine Temperatur, die entweder nicht niedriger als die Dissoziationstemperatur der blockierten Carbonsäure oder nicht niedriger als der Schmelzpunkt der Lötpartikel (4) ist, abhängig davon, welche höher ist.

## Revendications

1. Feuille de jonction (5), comprenant :

   des particules de brasure (4), une résine thermodurcissable, une résine thermoplastique et un acide carboxylique bloqué.

2. Feuille de jonction selon la revendication 1, dans laquelle

l'acide carboxylique bloqué est un produit issu de la réaction entre un éther de vinyle et un acide carboxylique.

**3.** Feuille de jonction selon la revendication 2, dans laquelle l'éther de vinyle est un alkyl vinyl éther et l'acide carboxylique est un acide carboxylique bifonctionnel.

**4.** Feuille de jonction selon la revendication 1, 2 ou 3, dans laquelle la température de dissociation de l'acide carboxylique bloqué est supérieure ou égale à 150 °C.

**5.** Feuille de jonction selon la revendication 1, 2, 3 ou 4, dans laquelle le rapport en volume de la résine thermodurcissable sur la résine thermoplastique est de 25/75 à 75/25.

**6.** Feuille de jonction selon la revendication 1, 2, 3, 4 ou 5, dans laquelle la résine thermodurcissable est une résine époxy.

**7.** Feuille de jonction selon la revendication 1, 2, 3, 4, 5 ou 6, dans laquelle la résine thermoplastique est une résine acrylique.

**8.** Feuille de jonction selon la revendication 1, 2, 3, 4, 5, 6 ou 7, dans laquelle les particules de brasure sont faites d'un alliage d'étain et de bismuth.

**9.** Feuille de jonction selon la revendication 1, 2, 3, 4, 5, 6, 7 ou 8 dans laquelle la feuille de jonction contient en outre un agent de durcissement.

**10.** Procédé de production d'une feuille de jonction (5), comprenant :

la préparation d'un mélange par le mélange de particules de brasure (4), d'une résine thermodurcissable, d'une résine thermoplastique et d'un acide carboxylique bloqué, pour chauffer le mélange à une température qui est inférieure à la température de dissociation de l'acide carboxylique bloqué et inférieure à la température de fusion des particules de brasure, et qui n'est pas inférieure à la température de ramollissement de la résine thermoplastique à former sous la forme d'une feuille.

**11.** Procédé de production d'un composant électronique (9), comprenant les étapes suivantes :

la préparation d'un stratifié dans lequel une feuille de jonction (5) est disposée entre deux morceaux de cartes de circuit imprimé (2) agencés de façon que leurs bornes (1) correspondantes soient espacées selon une relation opposée les unes par rapport aux autres, dans laquelle
la feuille de jonction (5) est une feuille de jonction selon la revendication 1 ; et
le chauffage du stratifié à une température qui soit n'est pas inférieure à la température de dissociation de l'acide carboxylique bloqué, soit n'est pas inférieure à la température de fusion des particules de brasure (4), quelle que soit celle qui est la plus élevée.

FIG. 1(a)

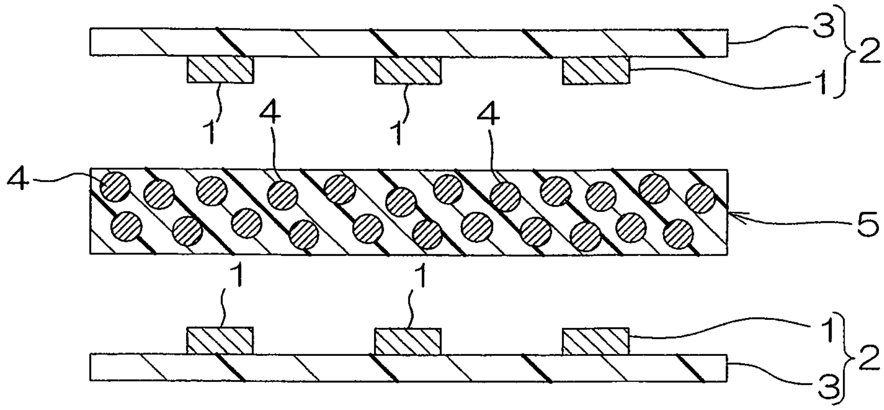


FIG. 1(b)

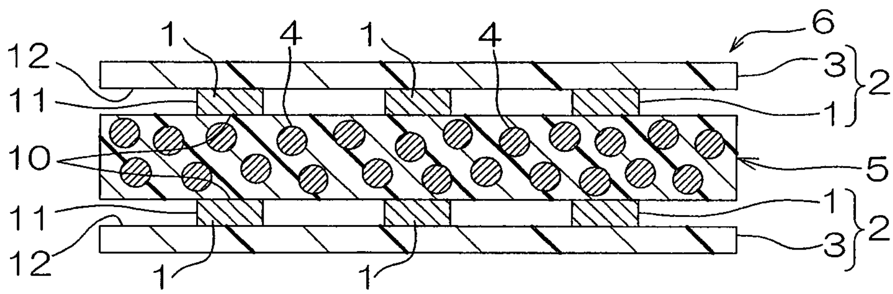


FIG. 1(c)

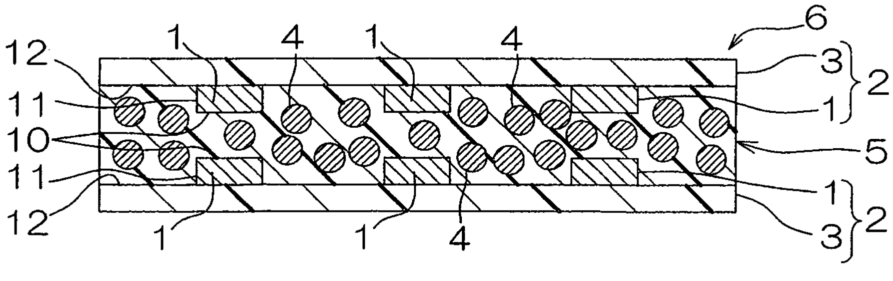


FIG. 1(d)

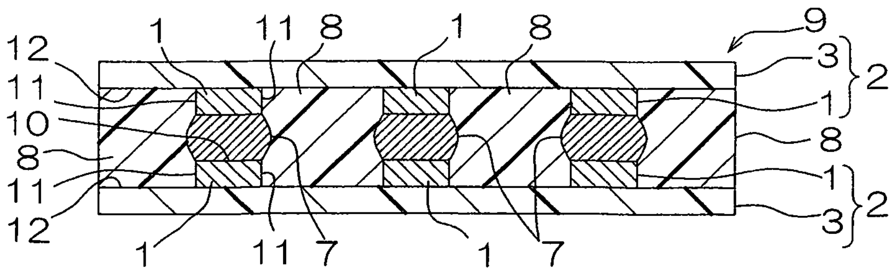

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006150413 A
- US 7838984 B2
- US 7575150 B2